# EUROPÄISCHE PATENTANMELDUNG

(11) **EP 3 582 253 A1**
(43) Veröffentlichungstag der Anmeldung: **18.12.2019**
(21) Anmeldenummer: 19179853.7
(22) Anmeldetag: 13.06.2019
(51) Int. Cl.: H01L 21/56, H01L 23/29

(54) **IONENMANIPULATIONSVERFAHREN UND ZUGEHÖRIGE VORRICHTUNGEN UND SYSTEME FÜR HALBLEITEREINKAPSELUNGSMATERIALIEN**

(30) Priorität: 13.06.2018 US 201816007038
(71) Anmelder: Infineon Technologies AG, 85579 Neubiberg (DE)
(72) Erfinder: DJEMOUR, Rabie, 80333 München (DE); BAUER, Michael, 93152 Nittendorf (DE); MIETHANER, Stefan, 93051 Regensburg (DE)
(74) Vertreter: Lambsdorff & Lange Patentanwälte Partnerschaft mbB

(57) **Zusammenfassung**

Ein Verfahren zum Manipulieren von Ionen, die in einem Verkapselungsmaterial für eine Halbleitervorrichtung enthalten sind, ist vorgesehen. Das Verfahren beinhaltet das Verarbeiten des Verkapselungsmaterials und das Anlegen eines elektrischen Feldes an das Verkapselungsmaterial, bevor das Verkapselungsmaterial endgültig ausgehärtet wird. Die im Verkapselungsmaterial enthaltenen Ionen weisen eine Mobilität auf, die mit zunehmender Aushärtung des Verkapselungsmaterials abnimmt. Durch Anlegen des elektrischen Feldes an das Verkapselungsmaterial vor der endgültigen Aushärtung des Verkapselungsmaterials wird die im Verkapselungsmaterial enthaltene Ionenmenge reduziert und/oder die enthaltenen Ionen werden in einem oder mehreren Bereichen des Verkapselungsmaterials konzentriert. Entsprechende Vorrichtungen und nach dem Verfahren hergestellte Halbleitergehäuse werden ebenfalls beschrieben.

## Beschreibung

### HINTERGRUND

Mobile Ionen oder Ladungen in Dieeinkapselungsmaterialien wie beispielsweise Formmassen können die Zuverlässigkeit von eingekapselten Halbleitergehäusen beeinträchtigen. Dieses Problem verschärft sich bei Produkten, die hohen Betriebsspannungen standhalten müssen und/oder extremen Betriebsbedingungen wie hohen Temperaturen über 150°C ausgesetzt sind. Die Wahrscheinlichkeit, dass Ionen über die Lebensdauer eines gekapselten Halbleitergehäuses in kritische Bereiche des Gehäuses wandern, steigt bei höheren Betriebstemperaturen und Spannungen. Eine übermäßige Ionenwanderung kann die elektrischen Parameter und die Funktionalität des gekapselten Halbleitergehäuses negativ beeinflussen. Daher sind verbesserte Techniken zur Begrenzung der Ionenmigration in eingekapselten Halbleitergehäusen erforderlich.

### ZUSAMMENFASSUNG

Gemäß einer Ausführungsform eines Verfahrens umfasst das Verfahren: Verarbeiten eines Verkapselungsmaterials für eine Halbleitervorrichtung, wobei das Verkapselungsmaterial Ionen enthält, die eine Mobilität aufweisen, die beim Aushärten des Verkapselungsmaterials abnimmt; und Anlegen eines elektrischen Feldes an das Verkapselungsmaterial, bevor das Verkapselungsmaterial schließlich ausgehärtet wird, um die Menge der im Verkapselungsmaterial enthaltenen Ionen zu reduzieren und/oder die im Verkapselungsmaterial enthaltenen Ionen in einem oder mehreren Bereichen des Verkapselungsmaterials zu konzentrieren.

Gemäß einer Ausführungsform eines Halbleitergehäuses umfasst das Halbleitergehäuse: einen Halbleiterdie; ein Verkapselungsmaterial, das den Halbleiterdie kontaktiert; und eine erste Gruppe von Ionen, die in dem Verkapselungsmaterial in einem ersten Abstand von dem Halbleiterdie konzentriert sind.

Gemäß einer Ausführungsform einer Vorrichtung umfasst die Vorrichtung: ein Gehäuse, das konfiguriert ist, um ein Verkapselungsmaterial für eine Halbleitervorrichtung aufzunehmen, wobei das Verkapselungsmaterial Ionen enthält, die eine Mobilität aufweisen, die abnimmt, wenn das Verkapselungsmaterial aushärtet; mindestens ein Paar Elektroden, die konfiguriert sind, um ein elektrisches Feld an das Verkapselungsmaterial anzulegen, das von dem Gehäuse empfangen wird, bevor das Verkapselungsmaterial schließlich ausgehärtet wird, um die Menge der im Verkapselungsmaterial enthaltenen Ionen zu reduzieren und/oder die im Verkapselungsmaterial enthaltenen Ionen in einem oder mehreren Bereichen des Verkapselungsmaterials zu konzentrieren; und eine Leistungsquelle, die konfiguriert ist, um eine Spannung über das mindestens eine Paar von Elektroden bereitzustellen.

Fachkräfte erkennen zusätzliche Merkmale und Vorteile beim Lesen der folgenden ausführlichen Beschreibung und beim Betrachten der beigefügten Zeichnungen.

### KURZBESCHREIBUNG DER ZEICHNUNGEN

Die Elemente der Zeichnungen müssen nicht unbedingt relativ zueinander skaliert werden. Gleiche Referenzziffern bezeichnen entsprechende gleiche oder ähnliche Teile. Die Merkmale der verschiedenen veranschaulichten Ausführungsformen können kombiniert werden, sofern sie sich nicht gegenseitig ausschließen. Ausführungsformen sind in den Zeichnungen dargestellt und werden in der folgenden Beschreibung ausführlich beschrieben.
Figur 1 veranschaulicht eine Ausführungsform eines Verfahrens zur Manipulation von Ionen, die in einem Verkapselungsmaterial für eine Halbleitervorrichtung enthalten sind.
Figur 2 veranschaulicht ein generisches Blockdiagramm einer Ausführungsform der Implementierung des in Figur 1 dargestellten Ionenmanipulationsverfahrens in einem System zur Herstellung eines Formverbundkapselungsmaterials.
Figur 3 veranschaulicht ein generisches Blockdiagramm einer Ausführungsform des in Figur 1 dargestellten Ionenmanipulationsverfahrens in einem System zum Verkapseln einer Halbleitervorrichtung in einem Formverbundkapselungsmaterial.
Die Figuren 4 bis 9 veranschaulichen jeweils schematische Diagramme von Ausführungsformen, in denen das in Figur 1 dargestellte Ionenmanipulationsverfahren mit einem Gehäuse verwendet wird, das konfiguriert ist, um ein Verkapselungsmaterial für eine Halbleitervorrichtung aufzunehmen, wobei das Verkapselungsmaterial Ionen enthält, die eine Mobilität aufweisen, die beim Aushärten des Verkapselungsmaterials abnimmt.
Figur 10A veranschaulicht ein schematisches Diagramm einer Ausführungsform eines Systems, das konfiguriert ist, um das in Figur 1 dargestellte Ionenmanipulationsverfahren in einem Formhohlraumgehäuse zu implementieren, das konfiguriert ist, um ein geschmolzenes oder verflüssigtes Formverbundkapselungsmaterial aufzunehmen, das Ionen enthält, die eine Mobilität aufweisen, die abnimmt, wenn das Kapselungsmaterial aushärtet.
Figur 10B veranschaulicht ein schematisches Diagramm einer Ausführungsform eines Systems, das konfiguriert ist, um das in Figur 1 dargestellte Ionenmanipulationsverfahren in einer Kammer zu implementieren, die konfiguriert ist, um ein PCB- oder eWLB-Kapselungsmaterial aufzunehmen, das Ionen enthält, deren Mobilität mit zunehmender Aushärtung des Kapselungsmaterials abnimmt.
Figur 11 veranschaulicht ein schematisches Diagramm einer Ausführungsform eines Systems, das konfiguriert ist, um das in Figur 1 dargestellte Ionenmanipulationsverfahren in einem Aushärteofen zu implementieren.
Die Figuren 12 bis 14 veranschaulichen die jeweiligen Ausführungsformen einer gehäusten Halbleitervorrichtung, die mit dem in Figur 1 dargestellten Ionenmanipulationsverfahren verarbeitet wurde.
Die Figuren 15A bis 15C veranschaulichen eine Ausführungsform des Entfernens einer oder mehrerer Gruppen konzentrierter Ionen innerhalb des Verkapselungsmaterials einer verpackten Halbleitervorrichtung, die mit dem in Figur 1 dargestellten Ionenmanipulationsverfahren verarbeitet wurde.
Figur 16 veranschaulicht eine Ausführungsform einer gehäusten Halbleitervorrichtung, die mit dem in Figur 1 dargestellten Ionenmanipulationsverfahren verarbeitet wurde und eine Getterstruktur zum Gettern (Einfangen) der Ionen, die von der Oberfläche der Halbleitervorrichtung durch das Ionenmanipulationsverfahren entfernt wurden, beinhaltet.

### DETAILLIERTE BESCHREIBUNG

Die hierin beschriebenen Ausführungsformen stellen Verfahren und zugehörige Vorrichtungen und Systeme zur Manipulation von Ionen in Verkapselungsmaterialien für Halbleitervorrichtungen bereit. Ionen können in einem Verkapselungsmaterial als Teil des Materialherstellungsprozesses gebildet und/oder hinzugefügt werden, können an der Oberfläche einer Halbleitervorrichtung vorhanden sein, die zumindest teilweise mit einem Verkapselungsmaterial bedeckt ist, können während des Verkapselungsprozesses eingeführt werden. Mobiles Natrium ist besonders problematisch und findet sich typischerweise in gängigen Formmassen, bei denen die Quelle z.B. Aluminiumhydroxid (flammhemmend) sein kann. Andere Arten von mobilen Ionen, die in einem Verkapselungsmaterial einer Halbleitervorrichtung vorhanden sind, können ebenfalls elektrische Parameter und die Funktionalität der Halbleitervorrichtung beeinflussen, die zumindest teilweise durch das Verkapselungsmaterial abgedeckt sind.

Durch Anlegen eines elektrischen Feldes an das Verkapselungsmaterial vor dem endgültigen Aushärten des Verkapselungsmaterials kann die Menge der im Verkapselungsmaterial enthaltenen Ionen reduziert und/oder die im Verkapselungsmaterial enthaltenen Ionen in einem oder mehreren weniger kritischen Bereichen des Verkapselungsmaterials konzentriert werden, die weniger Einfluss auf die elektrischen Parameter und die Funktionalität einer Halbleitervorrichtung haben, die zumindest teilweise durch das Verkapselungsmaterial abgedeckt ist.

Ionen, die in Verkapselungsmaterialien für Halbleiterbauelemente enthalten sind, weisen typischerweise eine Mobilität auf, die mit der Aushärtung abnimmt. Daher können die hierin beschriebenen Verfahren, Vorrichtungen und Systeme bei der Herstellung eines Verkapselungsmaterials, beim Aufbringen eines Verkapselungsmaterials auf eine Halbleitervorrichtung und/oder beim Aushärten eines Verkapselungsmaterials verwendet werden.

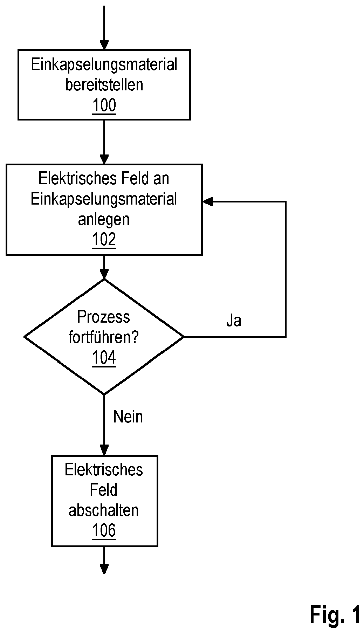

Figur 1 veranschaulicht eine Ausführungsform eines Verfahrens zur Manipulation von Ionen, die in einem Verkapselungsmaterial für eine Halbleitervorrichtung enthalten sind. Das Verkapselungsmaterial enthält Ionen, deren Mobilität mit zunehmender Aushärtung des Verkapselungsmaterials abnimmt. So kann beispielsweise das Verkapselungsmaterial eine Formmasse und/oder ein Harz sein, das in Spritzguss, Formpressen, folienunterstütztem Formen (FAM), Reaktionsspritzguss (RIM), Harztransferguss (RTM), Blasformen usw. verwendet wird. Zu den gebräuchlichen Formmassen und Harzen gehören unter anderem duroplastische Harze, Gel-Elastomere, Verkapselungsmittel, Vergussmassen, Verbundwerkstoffe, optische Materialien usw. Formmassen werden typischerweise als Pellets, Filme, Flüssigkeiten und/oder Pulver geliefert. Andere Arten von Verkapselungsmaterialien für Halbleitervorrichtungen, die Ionen mit einer abnehmenden Mobilität enthalten, wie sie bei der Aushärtung des Verkapselungsmaterials auftreten können, können enthalten, sind aber nicht beschränkt auf ein standardisolierende PCB-(gedruckte Leiterplatten)Materialien mit oder ohne Glasfasern, Polymerfilme oder Stapel von Polymerfilmen, ein standardisolierendes eWLB-(embedded wafer level ball grid array)Material, etc.

Das in Figur 1 dargestellte Verfahren beinhaltet die Verarbeitung des Verkapselungsmaterials (Block 100). Die Art der Verarbeitung des Verkapselungsmaterials kann von der Art des Materials und/oder dem Stand der Herstellung/Verwendung abhängen.

Im Falle der Herstellung eines Verkapselungsmaterials vom Typ einer Formmasse (MC) kann die Verarbeitung (Block 100) beispielsweise das Pressen eines verflüssigten Basismaterials beinhalten, das zum Bilden des MC-Kapselungsmaterials durch eine Leitung verwendet wird. Das verflüssigte Basismaterial kann ein Harz sein, und mögliche Füllstoffe und/oder Additive wie Glasfaserverstärkungen, Flammschutzmittel, Härter usw. können dem Basismaterial zugesetzt werden.

Im Falle des Auftragens des Verkapselungsmaterials auf eine Halbleitervorrichtung, z.B. durch Formen, PCB-Verkapselung, eWLB-Verkapselung usw., kann die Verarbeitung (Block 100) das Einsetzen des Verkapselungsmaterials in eine Kammer oder einen Formhohlraum beinhalten. Die Kammer oder der Formhohlraum beinhaltet jede Halbleitervorrichtung, die zumindest teilweise mit dem Verkapselungsmaterial bedeckt ist. Zum Formen kann das Verkapselungsmaterial verflüssigt und durch eine Leitung in einen Formhohlraum gedrückt werden. Für die Verkapselung von Leiterplatten und eWLB kann das Verkapselungsmaterial in eine Verarbeitungskammer eingebracht werden.

Nach dem Verkapseln kann die Verarbeitung (Block 100) das Aushärten des Verkapselungsmaterials in einem Aushärteofen beinhalten.

Das Verfahren beinhaltet ferner das Anlegen eines elektrischen Feldes an das Verkapselungsmaterial, bevor das Verkapselungsmaterial endgültig ausgehärtet wird (Block 102). Die Art und Weise, wie das elektrische Feld angelegt wird, kann von der Art des Materials und/oder dem Stand der Herstellung/Verwendung abhängen.

Im Falle der Herstellung des Verkapselungsmaterials kann beispielsweise das elektrische Feld (Block 102) an das verflüssigte Basismaterial angelegt werden, das zur Herstellung eines MC-Kapselungsmaterials verwendet wird, indem eine Spannung an mindestens ein Paar Elektroden angelegt wird, die außerhalb der Leitung oder dem Rohr angeordnet sind, die das verflüssigte Basismaterial trägt, innerhalb der Leitung angeordnet ist oder die Teil der Leitung bilden. Positive Ionen, wie beispielsweise Natrium, das in dem durch die Leitung strömenden verflüssigten Basismaterial enthalten ist, werden von jeder negativ geladenen Elektrode angezogen, und negative Ionen, die in dem verflüssigten Material enthalten sind, werden von jeder positiv geladenen Elektrode angezogen. Die Elektroden können regelmäßig gereinigt werden, z.B. durch Spülen der Leitung, um Ionenansammlungen im Inneren der Leitung zu vermeiden.

Im Falle des Aufbringens des Verkapselungsmaterials auf eine Halbleitervorrichtung, z.B. durch Formen, kann das elektrische Feld (Block 102) an ein verflüssigtes MC-Kapselungsmaterial angelegt werden, wenn es durch eine Leitung und in einen Formhohlraum fließt, indem eine Spannung an mindestens ein Paar von Elektroden angelegt wird, die außerhalb der Leitung angeordnet sind, innerhalb der Leitung angeordnet sind oder die Teil der Leitung bilden. Die Elektroden können regelmäßig gereinigt werden, z.B. durch Spülen der Leitung, um Ionenansammlungen im Inneren der Leitung zu vermeiden. Für die PCB- und eWLB-Verkapselung kann das elektrische Feld (Block 102) auf das PCB- oder eWLB-Verkapselungsmaterial innerhalb einer Verarbeitungskammer angelegt werden, indem eine Spannung an eine erste Elektrode angelegt wird, die von der Halbleitervorrichtung bereitgestellt wird, und an eine zweite Elektrode, die von der Halbleitervorrichtung in der Kammer beabstandet ist. Bei jedem Verkapselungsprozess werden die im Verkapselungsmaterial enthaltenen positiven Ionen von jeder negativ geladenen Elektrode und die im Verkapselungsmaterial enthaltenen negativen Ionen von jeder positiv geladenen Elektrode angezogen.

Während des Aushärtens des Verkapselungsmaterials kann das elektrische Feld an das Verkapselungsmaterial angelegt werden (Block 102), bevor das Verkapselungsmaterial schließlich ausgehärtet wird, indem eine Spannung an eine erste Elektrode angelegt wird, die von der verkapselten Halbleitervorrichtung bereitgestellt wird, und eine zweite Elektrode, die von der verkapselten Halbleitervorrichtung im Aushärteofen beabstandet ist. Positive Ionen, die im Verkapselungsmaterial enthalten sind, werden von jeder negativ geladenen Elektrode angezogen, wenn das Verkapselungsmaterial aushärtet, und negative Ionen, die im aushärtenden Verkapselungsmaterial enthalten sind, werden von jeder positiv geladenen Elektrode angezogen. Bei der PCB- und eWLB-Kapselung kann die Verarbeitungskammer, in der das PCB- oder eWLB-Kapselungsmaterial auf eine Halbleitervorrichtung aufgebracht wird, auch als Ofen für die endgültige Aushärtung des PCB- oder eWLB-Kapselungsmaterials dienen. In weiteren Ausführungsformen ist der Aushärteofen von der für den Verkapselungsprozess verwendeten Verarbeitungskammer getrennt.

In jedem dieser Beispiele befindet sich mindestens ein Elektrodenpaar in ausreichender Nähe zum Verkapselungsmaterial, so dass die im Verkapselungsmaterial enthaltenen positiven Ionen von jeder negativ geladenen Elektrode und die im Verkapselungsmaterial enthaltenen negativen Ionen von jeder positiv geladenen Elektrode angezogen werden. Durch Anlegen des elektrischen Feldes an das Verkapselungsmaterial vor dem endgültigen Aushärten des Verkapselungsmaterials wird die Menge der im Verkapselungsmaterial enthaltenen Ionen reduziert und/oder die im Verkapselungsmaterial enthaltenen Ionen werden in einem oder mehreren weniger kritischen Bereichen des Verkapselungsmaterials konzentriert, die weniger Einfluss auf die elektrischen Parameter und die Funktionalität der Halbleitervorrichtung haben, die zumindest teilweise durch das Verkapselungsmaterial abgedeckt sind. Das elektrische Feld kann für eine bestimmte Zeitspanne angelegt werden, oder bis eine Bedingung eintritt oder Kriterien erfüllt sind, z.B. Formgebung ist abgeschlossen, Endhärtung ist abgeschlossen, Sensoraktivierung, Sicherheitsunterbrechung, etc. (Block 104). Das elektrische Feld, das im Rahmen des Ionenmanipulationsverfahrens auf das Verkapselungsmaterial angelegt wird, kann konstant oder variabel sein (Änderung). Das Anlegen des elektrischen Feldes an das Verkapselungsmaterial wird bei Block 106 beendet.

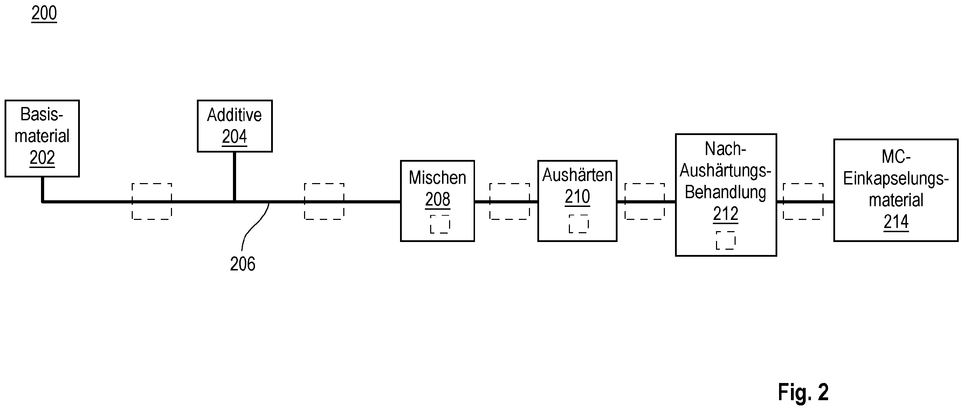

Figur 2 veranschaulicht ein generisches Blockdiagramm einer Ausführungsform des hierin beschriebenen und in Figur 1 dargestellten Ionenmanipulationsverfahrens in einem System 200 zur Herstellung eines MC (Mold Compound) Verkapselungsmaterials. Das System 200 beinhaltet eine Versorgung 202 für das Basismaterial wie ein Harz und eine Versorgung 204 für mögliche Füllstoffe und/oder Additive wie Glasfaserverstärkungen, Flammschutzmittel, Härter usw. Das System 200 beinhaltet eine oder mehrere Leitungen 206 zum Transport der Materialien zu einer Mischeinheit 208, die das Basismaterial und mögliche Füllstoffe und/oder Additive vermischt. Die Materialien können vor dem Mischen verflüssigt werden. Das System 200 beinhaltet eine Aushärteeinheit 210 zum optionalen Extrudieren und zumindest teilweisen Aushärten des Mischungsausgangs durch die Mischeinheit 208. Diese Stufe ermöglicht eine Zwischenhärtung. Die endgültige Aushärtung des Verkapselungsmaterials erfolgt, nachdem das Verkapselungsmaterial auf eine Halbleitervorrichtung aufgebracht wurde. Das System kann einen oder mehrere Nachhärtungsstufen 212 beinhalten. Das MC-Verkapselungsmaterial 214 ist dann bereit für die Anwendung auf einer Halbleitervorrichtung, z.B. in Pelletform, Filmform, Flüssigform, Pulverform, etc. Das hierin beschriebene und in Figur 1 dargestellte Ionenmanipulationsverfahren kann in jedem Stadium des in Figur 2 dargestellten MC-Herstellungsprozesses verwendet werden, in dem die Ionen im Material beweglich genug sind, um durch ein angelegtes elektrisches Feld bewegt zu werden. Die gestrichelten Kästen in Figur 2 zeigen exemplarische Phasen, in denen das Ionenmanipulationsverfahren angewendet werden kann.

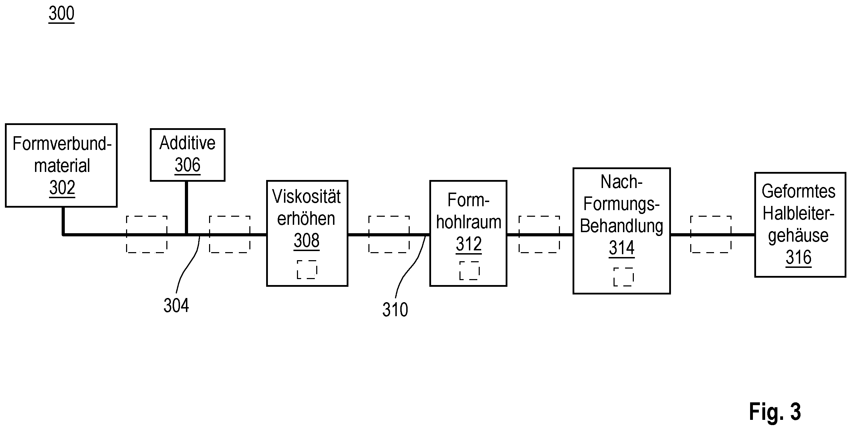

Figur 3 veranschaulicht ein generisches Blockdiagramm einer Ausführungsform des hierin beschriebenen und in Figur 1 dargestellten Ionenmanipulationsverfahrens in einem System 300 zum Verkapseln einer Halbleitervorrichtung in einem MC-(Formverbund-)Verkapselungsmaterial. Das System 300 beinhaltet einen Vorrat 302 für das MC-Verkapselungsmaterial wie z.B. ein duroplastisches Harz, Gel-Elastomer, Verkapselungsmittel, Vergussmasse, Verbundwerkstoff, optisches Material, etc. Das System 300 beinhaltet eine oder mehrere Leitungen oder Leitungen 304 zum Transport des MC-Verkapselungsmaterials und möglicher Zusatzstoffe wie Dies, Härter usw. zu einer Viskositätseinheit 308. Die Viskositätseinheit 308 erhöht die Viskosität des MC-Verkapselungsmaterials und möglicher Additive, z.B. durch Schmelzen, Verflüssigen, etc. zum Pressen des MC-Verkapselungsmaterials in Hohlräume. Das System 300 beinhaltet ein weiteres Rohr oder Leitung 310 zum Tragen des geschmolzenen MC-Verkapselungsmaterials von der Viskositätseinheit 308 zu einem Formhohlraum 312, der die Halbleitervorrichtung enthält, die zumindest teilweise mit dem MC-Verkapselungsmaterial abgedeckt ist. Je nach Art des Formprozesses kann der Formhohlraum 312 geschlossen oder offen für einen Füllkolben sein. Beim Abkühlen des MC-Vergussmaterials kann es zu einer Zwischenaushärtung im Formhohlraum 312 kommen. Das System 300 kann eine oder mehrere Nachbehandlungsstufen 314 beinhalten, wie z.B. Trimmen, Verdünnen, Entgraten, Ritzen, etc. Das geformte Halbleitergehäuse 316 ist dann bereit für die endgültige Aushärtung. Das hierin beschriebene und in Figur 1 dargestellte Ionenmanipulationsverfahren kann in jeder Phase des in Figur 3 dargestellten Formprozesses angewendet werden, bei dem die Ionen im Material beweglich genug sind, um durch ein angelegtes elektrisches Feld bewegt zu werden. Die gestrichelten Kästen in Figur 3 zeigen exemplarische Phasen, in denen das Ionenmanipulationsverfahren angewendet werden kann.

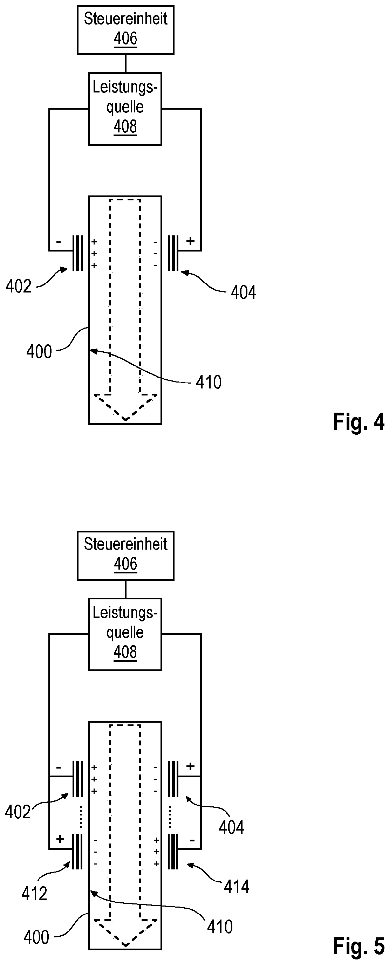

Die Figuren 4 bis 9 veranschaulichen Ausführungsformen, in denen das Ionenmanipulationsverfahren mit einem Gehäuse verwendet wird, das konfiguriert ist, um ein Verkapselungsmaterial für eine Halbleitervorrichtung aufzunehmen, wobei das Verkapselungsmaterial Ionen enthält, die eine Mobilität aufweisen, die beim Aushärten des Verkapselungsmaterials abnimmt. Selbst wenn die Mobilität einer Art von Ionen während der Aushärtung nicht abnimmt, könnte ein elektrisches Feld verwendet werden, um eine andere Art von Ionen aus kritischen Bereichen zu entfernen, was die Zuverlässigkeit der Vorrichtung verbessert. Eine zusätzliche Schicht kann vorgesehen werden, um Ionen mit abnehmender Mobilität einzufangen und/oder Ionen ohne abnehmende Mobilität zu bewegen. Die im Verkapselungsmaterial enthaltenen Ionen können Ionen sein, die natürlich im Verkapselungsmaterial vorkommen und/oder absichtlich oder unabsichtlich Ionen bei der Herstellung des Rohmaterials, aus dem das Verkapselungsmaterial oder das teilweise hergestellte Material hergestellt wird, zugegeben werden. In jedem Fall können Ionen auf der Oberfläche vor dem Formen mit den hierin beschriebenen Verfahren mit jeder Schicht gereinigt werden, bei der ein(e) Aushärtung/Feld angelegt werden kann. Im Allgemeinen ist die Quelle der Ionen irrelevant, solange die Ionen in einem elektrischen Feld beweglich sind.

Gemäß der in den Figuren 4 bis 9 dargestellten Ausführungsform ist das Gehäuse eine Leitung 400, die konfiguriert ist, um ein MC-Verkapselungsmaterial zu tragen, das durch einen nach unten gerichteten gestrichelten Pfeil gekennzeichnet ist. Die Leitung 400 kann jede Art von Rohr, Rohr, Leitung usw. sein, die zum Tragen des MC-Vergussmaterials vor der endgültigen Aushärtung verwendet wird. Das von der Leitung 400 getragene MC-Verkapselungsmaterial kann in seiner endgültigen Form kurz vor der Anwendung auf eine Halbleitervorrichtung vorliegen, kann in seiner Grundmaterialform vorliegen oder in einer Zwischenform vorliegen. So kann beispielsweise die Leitung 400 konfiguriert werden, um ein verflüssigtes Basismaterial zu tragen, das zur Bildung des MC-Verkapselungsmaterials verwendet wird, wie z.B. in Figur 2 dargestellt. Die Leitung 400 kann konfiguriert werden, um das MC-Verkapselungsmaterial im ungehärteten Zustand in eine Kammer oder einen Formhohlraum zu transportieren, wie z.B. in Figur 3 dargestellt. In jedem Fall ist mindestens ein Elektrodenpaar 402, 404 zum Anlegen eines elektrischen Feldes an das von der Leitung 400 getragene MC-Verkapselungsmaterial vorgesehen, bevor das MC-Verkapselungsmaterial endgültig ausgehärtet wird.

Figur 4 veranschaulicht eine Ausführungsform der Leitung 400, in der das mindestens eine Elektrodenpaar 402, 404 außerhalb der Leitung 400 angeordnet ist. Ein elektrisches Feld wird an das von der Leitung 400 getragene MC-Verkapselungsmaterial über das mindestens eine Elektrodenpaar 402, 404 angelegt. Eine Steuereinheit 406 kann zum Steuern einer Leistungsquelle 408 vorgesehen werden, die eine Spannung über das mindestens eine Elektrodenpaar 402, 404 anlegt, das außerhalb der Leitung 400 angeordnet ist. Die Steuereinheit 406 und die Leistungsquelle 408 können integrierte oder separate Komponenten sein. Die Steuereinheit 406 kann die Leistungsquelle 408 so steuern, dass über das mindestens eine Elektrodenpaar 402, 404 ein konstantes elektrisches Feld an das MC-Verkapselungsmaterial angelegt wird. In einer weiteren Ausführungsform kann die Steuereinheit 406 die Leistungsquelle 408 so steuern, dass ein sich änderndes elektrisches Feld, wie beispielsweise ein gepulstes elektrisches Feld, eine Spannungswellenform mit kontinuierlich steigendem Feld, eine Spannungswellenform mit kontinuierlich abnehmendem Feld, eine Spannungswellenform mit wechselnden Amplituden (auch innerhalb einer Polarität) usw., über das mindestens eine Elektrodenpaar 402, 404 an das MC-Kapselungsmaterial angelegt wird. Das heißt, das elektrische Feld kann konstant sein oder sich in Polarität und/oder Intensität in jeder geeigneten Kombination ändern.

In jedem Fall sind die im MC-Verkapselungsmaterial enthaltenen Ionen mobil genug, um durch das angelegte elektrische Feld bewegt zu werden. Positive Ionen (+), die in dem von der Leitung 400 getragenen MC-Kapselungsmaterial enthalten sind, werden von jeder negativ geladenen Elektrode 402 angezogen, und negative Ionen (-), die in dem von der Leitung 400 getragenen MC-Kapselungsmaterial enthalten sind, werden von jeder positiv geladenen Elektrode 404 angezogen. Das an das mindestens eine Elektrodenpaar 402, 404 angelegte elektrische Feld, das außerhalb der Leitung 400 angeordnet ist, hält (fängt) die Ionen entlang der Innenwände 410 der Leitung 400, so dass die Menge der im MC-Verkapselungsmaterial enthaltenen Ionen reduziert wird. Die Innenwände 410 der Leitung 400 können regelmäßig gereinigt werden, z.B. durch Spülen der Leitung, um Ionenansammlungen entlang der Innenwände zu vermeiden.

Figur 5 veranschaulicht eine weitere Ausführungsform der Leitung 400, in der mindestens ein zusätzliches Elektrodenpaar 412, 414 außerhalb der Leitung 400 angeordnet ist. Die in Figur 5 dargestellte Ausführungsform ähnelt der in Figur 4 dargestellten Ausführungsform. Im Unterschied dazu ist jedoch mindestens ein zusätzliches Elektrodenpaar 412, 414 mit der entgegengesetzten Spannungspolarität wie das erste Elektrodenpaar 402, 404 versehen. Gemäß dieser Ausführungsform werden positive Ionen (+), die in dem von der Leitung 400 getragenen MC-Kapselungsmaterial enthalten sind, von verschiedenen Seiten der Leitung 400 angezogen, ebenso wie negative Ionen (-), die in dem MC-Kapselungsmaterial enthalten sind.

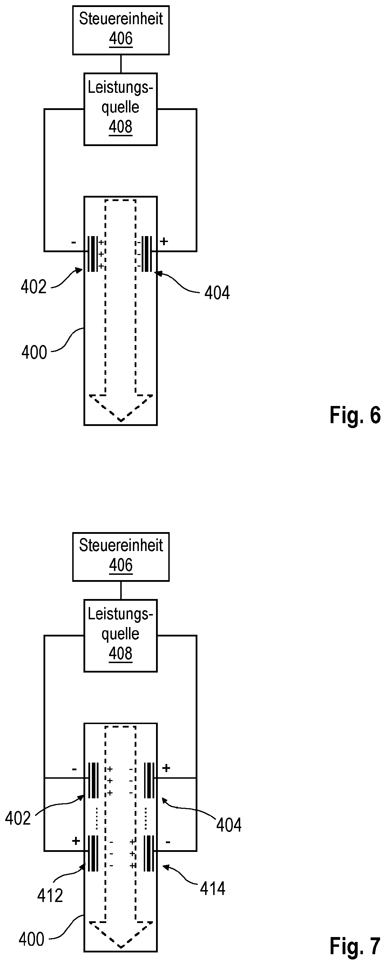

Figur 6 veranschaulicht eine Ausführungsform der Leitung 400, in der das mindestens eine Elektrodenpaar 402, 404 innerhalb der Leitung 400 angeordnet ist. Ein elektrisches Feld wird an das von der Leitung 400 getragene MC-Verkapselungsmaterial über das mindestens eine Elektrodenpaar 402, 404 angelegt. Eine Steuereinheit 406 kann eine Leistungsquelle 408 so steuern, dass ein konstantes oder sich änderndes elektrisches Feld über das mindestens eine Elektrodenpaar 402, 404, das innerhalb der Leitung 400 angeordnet ist, an das MC-Verkapselungsmaterial angelegt wird. Die im MC-Verkapselungsmaterial enthaltenen mobilen Ionen bewegen sich als Reaktion auf das angelegte elektrische Feld. Positive Ionen (+) werden von jeder negativ geladenen Elektrode 402 und negative Ionen (-) von jeder positiv geladenen Elektrode 404 angezogen. Das an das mindestens eine Elektrodenpaar 402, 404 angelegte elektrische Feld, das innerhalb der Leitung 400 angeordnet ist, hält (fängt) die Ionen gegen die Elektroden 402, 404, so dass die Menge der im MC-Verkapselungsmaterial enthaltenen Ionen reduziert wird. Die Elektroden 402, 404 können regelmäßig gereinigt werden, z.B. durch Spülen der Leitung, um Ionenansammlungen an den Elektroden 402, 404 zu vermeiden.

Figur 7 veranschaulicht eine weitere Ausführungsform der Leitung 400, in der mindestens ein zusätzliches Elektrodenpaar 412, 414 innerhalb der Leitung 400 angeordnet ist. Die in Figur 7 dargestellte Ausführungsform ähnelt der in Figur 6 dargestellten Ausführungsform. Im Unterschied dazu ist jedoch mindestens ein zusätzliches Elektrodenpaar 412, 414 mit der entgegengesetzten Spannungspolarität wie das erste Elektrodenpaar 402, 404 vorgesehen. Gemäß dieser Ausführungsform werden positive Ionen (+), die in dem von der Leitung 400 getragenen MC-Kapselungsmaterial enthalten sind, von den Elektroden 402, 414 auf verschiedenen Seiten der Leitung 400 angezogen, ebenso wie negative Ionen (-), die in dem MC-Kapselungsmaterial enthalten sind.

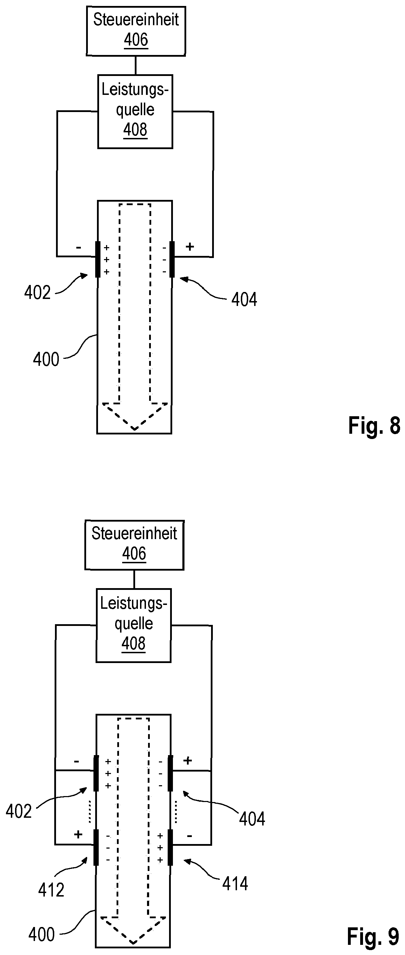

Figur 8 veranschaulicht eine Ausführungsform der Leitung 800, in der das mindestens eine Elektrodenpaar 402, 404 Teil der Leitung 400 ist. So kann beispielsweise das mindestens eine Elektrodenpaar 402, 404 in die Wandstruktur der Leitung 400 integriert werden. In einem weiteren Beispiel können die Wände der Leitung 400 oder Bereiche der Wände elektrisch segmentiert werden, um das mindestens eine Elektrodenpaar 402, 404 zu bilden. In beiden Fällen wird ein elektrisches Feld an das von der Leitung 400 getragene MC-Verkapselungsmaterial über das mindestens eine Paar Elektroden 402, 404 angelegt, die Teil der Leitung 400 sind. Eine Steuereinheit 406 kann eine Leistungsquelle 408 so steuern, dass über das mindestens eine Elektrodenpaar 402, 404 ein konstantes oder sich änderndes elektrisches Feld an das MC-Verkapselungsmaterial angelegt wird. Die im MC-Verkapselungsmaterial enthaltenen mobilen Ionen bewegen sich als Reaktion auf das angelegte elektrische Feld. Positive Ionen (+) werden von jeder negativ geladenen Elektrode 402 und negative Ionen (-) von jeder positiv geladenen Elektrode 404 angezogen. In Figur 8 hält (fängt) das an das mindestens eine Paar von Elektroden 402, 404, die Teil der Leitung 400 sind, die Ionen gegen den Teil der Leitungswände mit den integrierten Elektroden 402, 404, so dass die Menge der im MC-Verkapselungsmaterial enthaltenen Ionen reduziert wird. Die Innenwände der Leitung 400 können regelmäßig gereinigt werden, z.B. durch Spülen der Leitung, um Ionenansammlungen an den Innenwänden zu vermeiden.

Figur 9 veranschaulicht eine weitere Ausführungsform der Leitung 400, in der mindestens ein zusätzliches Elektrodenpaar 412, 414 Teil der Leitung 400 ist. Die in Figur 9 dargestellte Ausführungsform ähnelt der in Figur 8 dargestellten Ausführungsform. Im Unterschied dazu ist jedoch mindestens ein zusätzliches Elektrodenpaar 412, 414, das in die Wandstruktur der Leitung 400 integriert ist, mit der entgegengesetzten Spannungspolarität wie das erste Paar integrierter Elektroden 402, 404 vorgesehen. Gemäß dieser Ausführungsform werden positive Ionen (+), die in dem von der Leitung 400 getragenen MC-Kapselungsmaterial enthalten sind, von den Elektroden 402, 424, die auf verschiedenen Seiten der Leitung 400 integriert sind, angezogen, ebenso wie negative Ionen (-), die in dem MC-Kapselungsmaterial enthalten sind.

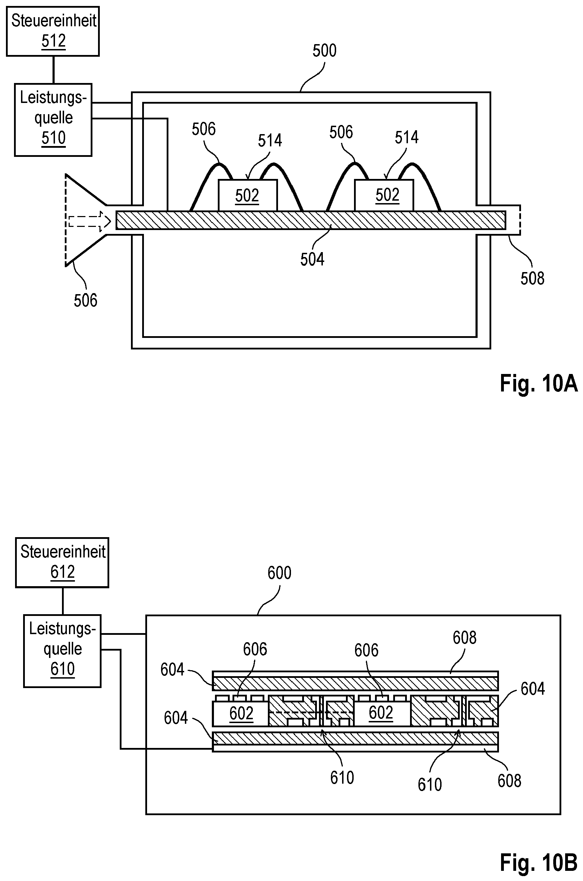

Figur 10A veranschaulicht eine Ausführungsform, bei der das hierin beschriebene Ionenmanipulationsverfahren mit einem Gehäuse verwendet wird, das konfiguriert ist, um ein Verkapselungsmaterial für eine Halbleitervorrichtung aufzunehmen, wobei das Verkapselungsmaterial Ionen enthält, die eine Mobilität aufweisen, die beim Aushärten des Verkapselungsmaterials abnimmt. Gemäß der in Figur 10A dargestellten Ausführungsform ist das Gehäuse ein Formhohlraum 502, der konfiguriert ist, um ein geschmolzenes oder verflüssigtes MC-Verkapselungsmaterial aufzunehmen, das Ionen enthält, deren Mobilität beim Aushärten des Verkapselungsmaterials abnimmt, und eine oder mehrere Halbleitervorrichtungen 502, die zumindest teilweise durch das MC-Verkapselungsmaterial abgedeckt sind. Das MC-Verkapselungsmaterial ist in Figur 10A durch einen nach rechts gerichteten gestrichelten Pfeil gekennzeichnet.

Jede Halbleitervorrichtung 502 weist Anschlüsse auf, die elektrisch mit einem Substrat 504 verbunden sind, wie beispielsweise einem Leiterrahmen, einer Leiterplatte, einem keramischen Substrat mit einer metallisierten Seite usw. Die elektrischen Anschlüsse 506 sind in Figur 10A nur zur besseren Veranschaulichung als Bonddrahtverbindungen dargestellt, jedoch können auch andere Arten von elektrischen Verbindungen wie Metallclips, Bänder, Lötballen usw. verwendet werden. Die Halbleitervorrichtungen 502 können jede Art von Halbleiterdie (Chip) oder Gehäuse sein, die zumindest teilweise durch das Verkapselungsmaterial abgedeckt werden soll. So kann beispielsweise jede Halbleitervorrichtung 502 eine passive Vorrichtung wie ein Induktor, Widerstand und/oder Kondensator oder eine aktive Vorrichtung wie eine Leistungsvorrichtung wie ein Leistungstransistor, eine Leistungsdiode usw., eine logische Vorrichtung wie ein Controller, ASIC (anwendungsspezifische integrierte Schaltungen) usw., eine Speichervorrichtung, ein Sensor, ein MEMS (mikroelektromechanische Systeme) usw. sein.

Unabhängig von der Art und Menge der Halbleitervorrichtungen 502 beinhaltet der Formhohlraum 500 einen Eingang 506 zur Aufnahme des verflüssigten MC-Verkapselungsmaterials, während es durch eine Leitung (nicht dargestellt) und in den Formhohlraum 500 fließt. Der Formhohlraum 500 kann auch eine Entlüftung 508 beinhalten.

Ein elektrisches Feld kann an das MC-Verkapselungsmaterial innerhalb des Formhohlraums 500 durch eine von einer Steuereinheit 512 gesteuerte Leistungsquelle 510 angelegt werden. Die Steuereinheit 512 und die Leistungsquelle 510 können integrierte oder separate Komponenten sein. Die Steuereinheit 512 kann die Leistungsquelle 408 so steuern, dass ein konstantes elektrisches Feld an das MC-Verkapselungsmaterial im Formhohlraum 500 angelegt wird. In einer weiteren Ausführungsform kann die Steuereinheit 512 die Leistungsquelle 510 so steuern, dass ein sich änderndes elektrisches Feld an das MC-Verkapselungsmaterial innerhalb des Formhohlraums 500 angelegt wird. In beiden Fällen sind die im MC-Verkapselungsmaterial enthaltenen Ionen mobil genug, um durch das angelegte elektrische Feld bewegt zu werden.

Das elektrische Feld kann durch Anlegen einer Spannung an eine erste Elektrode erzeugt werden, die von der/den Halbleitervorrichtung(en) 502 im Formhohlraum 500 und einer zweiten Elektrode im Abstand von der/den Halbleitervorrichtung(en) 502 im Formhohlraum 500 bereitgestellt wird. Ein Anschluss der Leistungsquelle kann elektrisch mit dem Substrat 504 verbunden sein, an dem die Halbleitervorrichtung(en) 502 befestigt sind. In einigen Fällen können alle Anschlüsse jeder Halbleitervorrichtung 502 bis zur endgültigen Aushärtung über das Substrat 504 kurzgeschlossen werden, so dass sich als Reaktion auf das angelegte elektrische Feld keine großen Spannungen innerhalb der Vorrichtung(en) 502 aufbauen. Wenn die Anschlüsse jeder Halbleitervorrichtung 502 während des Verkapselungsprozesses nicht über das Substrat 504 kurzgeschlossen werden, sollte zusätzlich darauf geachtet werden, dass sich problematische Spannungen innerhalb der Vorrichtung(en) 502 als Reaktion auf das angelegte elektrische Feld nicht aufbauen. In beiden Fällen kann die Halbleitervorrichtung(en) 502, die in dem Formhohlraum 500 enthalten sind, eine Elektrode zum Anlegen des elektrischen Feldes an das MC-Verkapselungsmaterial bilden.

In einer Ausführungsform ist der Formhohlraum 500 oder ein Teil des Formhohlraums 500 elektrisch leitfähig und bildet die zweite Elektrode zum Anlegen des elektrischen Feldes an das Verkapselungsmaterial. Da Ionen an dieser Stelle des Herstellungsprozesses noch mobil sind, konzentriert das über die Elektroden im Formhohlraum 500 angelegte elektrische Feld die im MC-Verkapselungsmaterial enthaltenen mobilen Ionen in einem oder mehreren Bereichen des MC-Verkapselungsmaterials, die weniger Einfluss auf elektrische Parameter und Funktionalität der Halbleitervorrichtung(en) 502 haben. Die im MC-Kapselungsmaterial enthaltenen mobilen Ionen können in einem oder mehreren Bereichen des MC-Kapselungsmaterials konzentriert sein, die von der Oberfläche 512 der Halbleitervorrichtung(en) 502 in Kontakt mit dem MC-Kapselungsmaterial beabstandet sind.

Figur 10B veranschaulicht eine Ausführungsform, in der das Gehäuse eine Kammer 600 ist, die konfiguriert ist, um ein PCB- oder eWLB-Verkapselungsmaterial aufzunehmen, das Ionen enthält, deren Mobilität beim Aushärten des Verkapselungsmaterials abnimmt, und eine oder mehrere Halbleitervorrichtungen 602, die zumindest teilweise von dem Verkapselungsmaterial bedeckt sind. So kann beispielsweise jede Halbleitervorrichtung 602 zwischen Platten aus PCB- oder eWLB-Laminatschichten 604 platziert werden. Jede Halbleitervorrichtung 602 weist Klemmen 606 auf, die elektrisch durch Leiterbahnen 608 und/oder Durchkontaktierungen 610 verbunden sind, die sich durch die Oberflächen des PCB/eWLB Verkapselungsmaterials 604 erstrecken und/oder darauf gebildet sind. Die Halbleitervorrichtung(en) 602 können jede Art von Halbleiterdie (Chip) oder Gehäuse sein, die zumindest teilweise durch das PCB/eWLB Verkapselungsmaterial 604 abgedeckt werden soll. So kann beispielsweise jede Halbleitervorrichtung 602 eine passive Vorrichtung wie ein Induktor, Widerstand und/oder Kondensator oder eine aktive Vorrichtung wie eine Leistungsvorrichtung wie ein Leistungstransistor, eine Leistungsdiode usw., eine logische Vorrichtung wie ein Controller, ASIC (anwendungsspezifische integrierte Schaltungen) usw., eine Speichervorrichtung, ein Sensor, ein MEMS (mikroelektromechanische Systeme) usw. sein. Unabhängig von Art und Menge der Halbleitervorrichtungen 502 nimmt die Kammer 600 die Halbleitervorrichtung(en) 602 und das PCB / eWLB Verkapselungsmaterial 604 auf.

Ein elektrisches Feld kann an das PCB/eWLB-Verkapselungsmaterial 604 innerhalb der Kammer 600 durch eine von einer Steuereinheit 614 gesteuerte Leistungsquelle 612 angelegt werden. Die Steuereinheit 614 und die Leistungsquelle 612 können integrierte oder separate Komponenten sein. Die Steuereinheit 614 kann die Leistungsquelle 612 so steuern, dass ein konstantes elektrisches Feld auf das PCB / eWLB Verkapselungsmaterial 604 innerhalb der Kammer 600 angelegt wird. In einer weiteren Ausführungsform kann die Steuereinheit 614 die Leistungsquelle 612 so steuern, dass ein sich änderndes elektrisches Feld auf das PCB / eWLB Verkapselungsmaterial 604 innerhalb der Kammer 600 angelegt wird. In beiden Fällen sind die im PCB / eWLB Verkapselungsmaterial 604 enthaltenen Ionen mobil genug, um durch das angelegte elektrische Feld bewegt zu werden.

Das elektrische Feld kann durch Anlegen einer Spannung an eine erste Elektrode, die von der/den in der Kammer 600 enthaltenen Halbleitervorrichtung(en) 602 bereitgestellt wird, und an eine zweite Elektrode, die von der/den Halbleitervorrichtung(en) 602 in der Kammer 600 beabstandet ist, erzeugt werden. Eine Klemme der Leistungsquelle 612 kann elektrisch mit der/den Halbleitervorrichtung(en) 602 verbunden sein, z.B. durch eine oder mehrere der Leiterbahnen 608 und/oder Durchkontaktierungen 610, die sich durch die Oberflächen des PCB / eWLB Verkapselungsmaterials 604 erstrecken und/oder darauf gebildet sind. In einigen Fällen können alle Klemmen 606 jeder Halbleitervorrichtung 602 kurzgeschlossen sein, so dass sich in jeder Vorrichtung 602 als Reaktion auf das angelegte elektrische Feld keine großen Spannungen aufbauen. Wenn die Klemmen 606 einer Halbleitervorrichtung 602 während des Verkapselungsprozesses nicht kurzgeschlossen werden, sollte zusätzlich darauf geachtet werden, dass sich problematische Spannungen innerhalb dieser Vorrichtung 602 als Reaktion auf das angelegte elektrische Feld nicht aufbauen. In beiden Fällen bilden die in der Kammer 600 enthaltenen Halbleitervorrichtungen 602 eine Elektrode zum Anlegen des elektrischen Feldes an das PCB / eWLB Verkapselungsmaterial 604.

In einer Ausführungsform ist die Kammer 600 oder ein Teil der Kammer 600 elektrisch leitfähig und bildet die zweite Elektrode zum Anlegen des elektrischen Feldes an das PCB / eWLB Verkapselungsmaterial 604. Da Ionen an dieser Stelle des Herstellungsprozesses noch mobil sind, konzentriert das über die Elektroden in der Kammer 600 angelegte elektrische Feld die im PCB / eWLB Verkapselungsmaterial 604 enthaltenen mobilen Ionen in einem oder mehreren Bereichen des PCB / eWLB Verkapselungsmaterials 604, die weniger Einfluss auf elektrische Parameter und Funktionalität der Halbleitervorrichtung(en) 602 haben. Die im PCB / eWLB Verkapselungsmaterial 604 enthaltenen mobilen Ionen können in einem oder mehreren Bereichen des PCB / eWLB Verkapselungsmaterials 604 konzentriert sein, die von der Oberfläche der Halbleitervorrichtung (en) 502 in Kontakt mit dem PCB / eWLB Verkapselungsmaterial 604 beabstandet sind.

Wie vorstehend beschrieben, kann das Verkapselungsmaterial, auf das die hierin beschriebene Ionenmanipulationsmethode angewendet wird, ein beliebiges Standardkapselungsmaterial für Halbleitervorrichtungen sein, das Ionen enthält, deren Mobilität abnimmt, wenn das Verkapselungsmaterial aushärtet. So kann beispielsweise das Verkapselungsmaterial ein Standardisolierungsmaterial für Leiterplatten mit oder ohne Glasfasern, Polymerfolien oder Stapel von Polymerfolien, ein Standardisolierungsmaterial für eWLB usw. sein. Die Art des Gehäuses, in dem eine Halbleitervorrichtung zumindest durch das Verkapselungsmaterial abgedeckt ist, hängt von der Art des verwendeten Verkapselungsmaterials ab und kann leicht nachgerüstet werden, um die vorstehend beschriebene und in den Figuren 10A und 10B dargestellte Elektrodenkonfiguration aufzunehmen.

Standardformhohlräume und PCB/eWLB-Bearbeitungskammern umfassen typischerweise Metallkomponenten wie Metallplatten, Plattformen usw., die die zweite Elektrode bilden können, und die Halbleitervorrichtungen können leicht elektrisch kontaktiert werden, um die erste Elektrode zu bilden. Im Allgemeinen kann die zweite Elektrode eine zusätzliche Metallelektrode sein oder durch einen leitenden Teil realisiert werden, der bereits z.B. als Teil einer Formkammer, eines Aushärteofens usw. verwendet wird.

Ein elektrisches Feld wird über die Elektroden an das im Gehäuse enthaltene Verkapselungsmaterial angelegt. Es kann eine Steuereinheit zum Steuern einer Leistungsquelle vorgesehen werden, die eine Spannung an die Elektroden anlegt. Die Steuereinheit kann die Leistungsquelle so steuern, dass über die Elektroden ein konstantes elektrisches Feld an das Verkapselungsmaterial angelegt wird. In einer weiteren Ausführungsform kann die Steuereinheit die Leistungsquelle so steuern, dass über die Elektroden ein sich änderndes elektrisches Feld an das Verkapselungsmaterial angelegt wird. In beiden Fällen sind die im Verkapselungsmaterial enthaltenen Ionen mobil genug, um durch das angelegte elektrische Feld bewegt zu werden. Positive Ionen (+) im Verkapselungsmaterial werden von der negativ geladenen Elektrode angezogen, negative Ionen (-) im Verkapselungsmaterial von der positiv geladenen Elektrode.

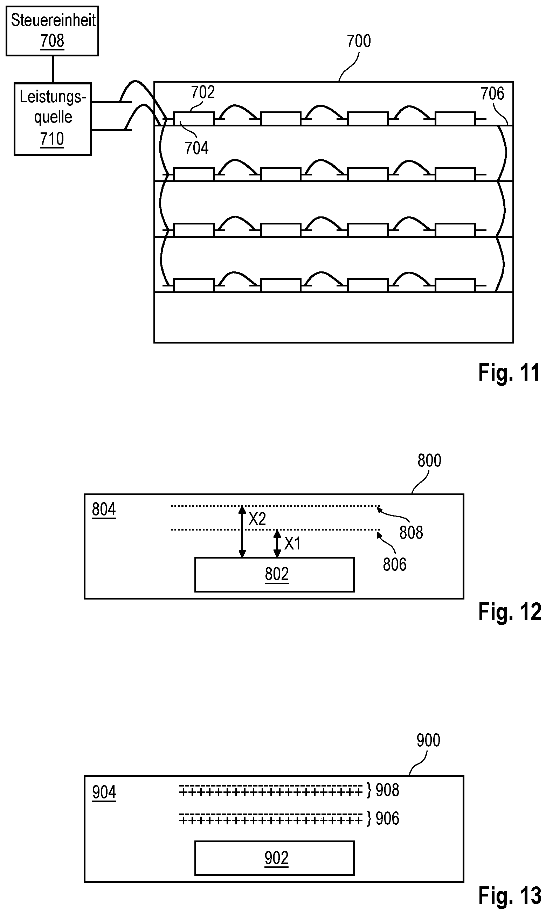

Figur 11 veranschaulicht eine Ausführungsform, bei der das hierin beschriebene Ionenmanipulationsverfahren mit einem Aushärteofen 700 verwendet wird, der konfiguriert ist, um ein Verkapselungsmaterial 702 von gepackten Halbleitervorrichtungen 704 auszuhärten. Der Aushärteofen 700 kann eine Vielzahl von gehäusten Halbleitervorrichtungen 704 aufnehmen. Jede gepackte Halbleitervorrichtung 704 beinhaltet eine oder mehrere Halbleitervorrichtungen und/oder Dies (außer Sichtweite) in Kontakt mit einem Verkapselungsmaterial 702. Das Verkapselungsmaterial 702 enthält Ionen, die mobil bleiben, da das Verkapselungsmaterial 702 noch nicht vollständig ausgehärtet ist. Durch Anlegen eines elektrischen Feldes an das Verkapselungsmaterial 702 vor dem endgültigen Aushärten des Verkapselungsmaterials 702 können die im Verkapselungsmaterial 702 enthaltenen Ionen in einem oder mehreren weniger kritischen Bereichen des Verkapselungsmaterials 702 konzentriert werden, die weniger Einfluss auf elektrische Parameter und Funktionalität der Halbleitervorrichtungen in Kontakt mit dem Verkapselungsmaterial 702 haben.

Eine erste Elektrode zum Anlegen des elektrischen Feldes wird von den gehäusten Halbleitervorrichtungen 704 bereitgestellt, und eine zweite Elektrode zum Anlegen des elektrischen Feldes ist von den gehäusten Halbleitervorrichtungen 704 im Härteofen 700 beabstandet. In einer Ausführungsform beinhaltet der Aushärteofen 700 ein oder mehrere Gestelle 706, auf denen die gepackten Halbleitervorrichtungen 704 während der Endaushärtung des Verkapselungsmaterials 702 liegen. In einer Ausführungsform bilden die Gestelle 706 die zweite Elektrode zum Anlegen des elektrischen Feldes und können innerhalb des Aushärteofens 700 z.B. über Jumper, Kabel, Drähte usw. elektrisch miteinander verbunden werden, wie in Figur 11 dargestellt. Die verpackten Halbleitervorrichtungen 704 können innerhalb des Aushärteofens 700 elektrisch miteinander verbunden werden, z.B. über Steckbrücken, Kabel, Drähte usw., wie auch in Figur 11 dargestellt, um die erste Elektrode zum Anlegen des elektrischen Feldes zu bilden. Die Verkabelung zwischen den gehäusten Halbleitervorrichtungen 704 kann nur die natürliche Verbindung innerhalb desselben Leadframes sein. In einigen Fällen dürfen die gehäusten Halbleitervorrichtungen 704 nicht als Elektrode verwendet werden, sondern es wird ein separates Elektrodenpaar (plus und minus) bereitgestellt, ohne die Vorrichtungen 704 zu berühren.

Ein elektrisches Feld wird über die Elektroden an das Verkapselungsmaterial 702 der verpackten Halbleitervorrichtungen 704 angelegt, das im Aushärteofen 700 enthalten ist. Eine Steuereinheit 708 kann zum Steuern einer Leistungsquelle 710 vorgesehen werden, die eine Spannung an die Elektroden anlegt. Die Steuereinheit 708 kann die Leistungsquelle 710 so steuern, dass über die Elektroden ein konstantes elektrisches Feld an das Verkapselungsmaterial 702 angelegt wird. In einer weiteren Ausführungsform kann die Steuereinheit 708 die Leistungsquelle 710 so steuern, dass über die Elektroden ein sich änderndes elektrisches Feld an das Verkapselungsmaterial 702 angelegt wird. In beiden Fällen sind die im Verkapselungsmaterial 702 jeder verpackten Halbleitervorrichtung 704 enthaltenen Ionen während des abschließenden Aushärtungsprozesses mobil genug, um durch das angelegte elektrische Feld bewegt zu werden. Positive Ionen (+) im Verkapselungsmaterial 702 werden von der negativ geladenen Elektrode angezogen, negative Ionen (-) im Verkapselungsmaterial 702 von der positiv geladenen Elektrode.

Figur 12 veranschaulicht eine Ausführungsform einer gehäusten Halbleitervorrichtung 800, die mit dem hierin beschriebenen Ionenmanipulationsverfahren zumindest während der Einbettung und/oder der endgültigen Aushärtung verarbeitet wird. Gemäß dieser Ausführungsform beinhaltet die verpackte Halbleitervorrichtung 800 einen Halbleiterdie 802 und ein Verkapselungsmaterial 804, das den Halbleiterdie 802 kontaktiert, wobei die verpackte Halbleitervorrichtung 800 mehr als einen Halbleiterdie 802 beinhalten kann. Ein Halbleiterdie 802 ist in Figur 12 nur zur besseren Veranschaulichung dargestellt.

Das hierin beschriebene Ionenmanipulationsverfahren führt dazu, dass eine erste Gruppe von Ionen 806 in dem Verkapselungsmaterial 804 in einem ersten Abstand X1 von dem Halbleiterdie 802 konzentriert wird, wobei eine zweite Gruppe von Ionen 808 in dem Verkapselungsmaterial 804 in einem zweiten Abstand X2 von dem Halbleiterdie 802 größer als der erste Abstand X1 konzentriert werden kann. Zusätzliche Gruppen von Ionen können im Verkapselungsmaterial 802 in noch weiterem Abstand zum Halbleiterdie 802 konzentriert werden, sind aber in Figur 12 zur besseren Veranschaulichung nicht dargestellt. Die Abstände X1, X2 können so gewählt werden, dass jede Gruppe von konzentrierten Ionen 806, 808 in einem weniger kritischen Bereich des Verkapselungsmaterials 804 angeordnet ist, was weniger Einfluss auf die elektrischen Parameter und die Funktionalität des Halbleiterdies 802 in Kontakt mit dem Verkapselungsmaterial 804 hat.

Abhängig von der Art und Weise, wie das elektrische Feld während der Verarbeitung an das Verkapselungsmaterial 804 angelegt wird, können im Verkapselungsmaterial unterschiedliche Anordnungen von positiven (+) und negativen (-) Ionenkonzentrationen realisiert werden. Die Ionenbeweglichkeit ändert sich (nimmt ab), wenn das Verkapselungsmaterial 804 aushärtet. So kann beispielsweise die Ionenmobilität zunächst hoch sein und sich dann mit der Zeit verringern, wenn das Verkapselungsmaterial 804 aushärtet. Negative Ionen sind größer und weniger beweglich als positive Ionen. In einer Ausführungsform kann zu Beginn des Ionenmanipulationsverfahrens eine negative Spannung an das Verkapselungsmaterial 804 angelegt werden, um bei hoher Mobilität negative (größere/langsamere) Ionen von dem Die 802 wegzudrücken. Die Spannungspolarität kann später auf positiv umgeschaltet werden, um bei abnehmender Mobilität positive (kleinere/schnellere) Ionen vom Die 802 wegzudrängen. Die negativen Ionen werden immer noch vom positiven (Geräte-)Potential angezogen, aber weit genug vom Die 802 und viel weniger mobil an diesem Punkt des Prozesses entfernt und sollten daher nicht wieder an ihren ursprünglichen Ort zurückkehren. Die positiven Ionen sind immer noch beweglich genug, um sich vom Die 802 zu entfernen, obwohl ihre Mobilität zurückgegangen ist. Der Umschaltpunkt von einer negativen Gerätespannung auf eine positive Gerätespannung kann durch Versuch und Irrtum und/oder basierend auf einer Mobilitätskurve für das zu messende Verkapselungsmaterial 804 bestimmt werden. In noch weiteren Ausführungsformen kann zuerst eine positive Gerätespannung und dann eine negative Spannung angelegt werden.

Figur 13 veranschaulicht eine Ausführungsform einer gehäusten Halbleitervorrichtung 900, die mit dem Ionenmanipulationsverfahren verarbeitet wurde, das mit einem Umschaltpunkt von einer negativen Vorrichtungsspannung auf eine positive Vorrichtungsspannung zumindest während der Einbettung und/oder Endhärtung der Vorrichtung implementiert wurde. Die verpackte Halbleitervorrichtung 900 beinhaltet einen Halbleiterdie 902 und ein Verkapselungsmaterial 904, das den Halbleiterdie 902 kontaktiert. Die verpackte Halbleitervorrichtung 900 kann mehr als einen Halbleiterdie 902 beinhalten. Ein Halbleiterchip 902 ist in Figur 13 nur zur besseren Veranschaulichung dargestellt. Eine erste Gruppe von Ionen 906, die in dem Verkapselungsmaterial 904 konzentriert sind, beinhaltet eine Schicht oder Verteilung von positiv geladenen Ionen (+), die von einer Schicht oder Verteilung von negativ geladenen Ionen (-) versetzt sind. Eine zweite Gruppe 908 von Ionen, die innerhalb des Verkapselungsmaterials 904 konzentriert sind, beinhaltet ebenfalls eine Schicht oder Verteilung von positiv geladenen Ionen (+), die von einer Schicht oder Verteilung von negativ geladenen Ionen (-) versetzt sind.

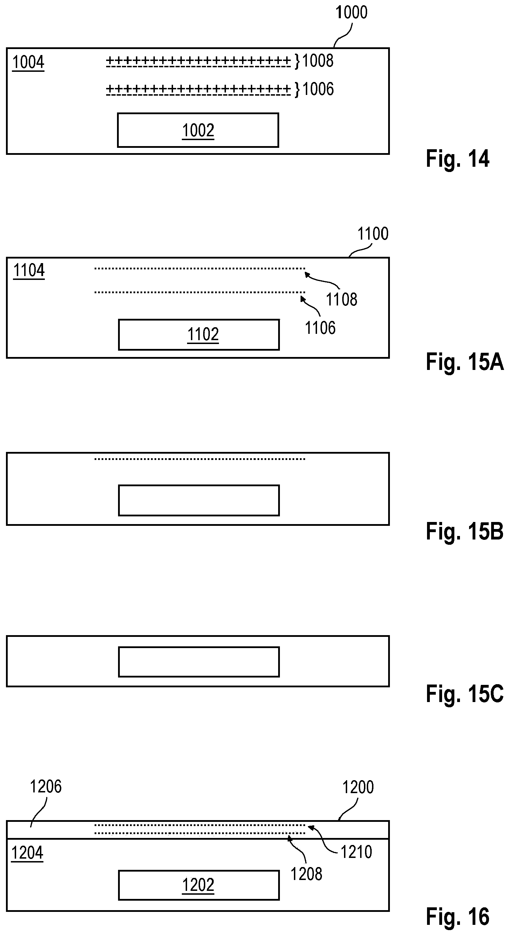

Figur 14 veranschaulicht eine Ausführungsform einer gehäusten Halbleitervorrichtung 1000, die mit dem Ionenmanipulationsverfahren verarbeitet wurde, das mit einem Umschaltpunkt von einer positiven Vorrichtungsspannung auf eine negative Vorrichtungsspannung zumindest während der Einbettung und/oder Endhärtung der Vorrichtung implementiert wurde. Die verpackte Halbleitervorrichtung 1000 beinhaltet einen Halbleiterdie 1002 und ein Verkapselungsmaterial 1004, das den Halbleiterdie 1002 kontaktiert. Die verpackte Halbleitervorrichtung 1000 kann mehr als einen Halbleiterdie 1002 beinhalten. Ein Halbleiterdie 1002 ist in Figur 14 nur zur besseren Veranschaulichung dargestellt.

Die in Figur 14 dargestellte Ausführungsform ist ähnlich der in Figur 13 dargestellten Ausführungsform. Anders jedoch ist die Schicht oder Verteilung der negativ geladenen Ionen (-) für jede Gruppe 1006, 1008 der im Verkapselungsmaterial 904 konzentrierten Ionen näher an dem Halbleiterdie 1002 angeordnet als die entsprechende Schicht oder Verteilung der positiv geladenen Ionen (+). Noch andere Ionenkonzentrationsprofile können gedacht werden. So kann beispielsweise eine Gruppe von konzentrierten Ionen innerhalb des Verkapselungsmaterials 1004 eine Schicht oder Verteilung von positiv geladenen Ionen (+) aufweisen, die über eine Schicht oder Verteilung von negativ geladenen Ionen (-) gestapelt sind, und eine andere Gruppe von konzentrierten Ionen innerhalb des Verkapselungsmaterials 1004 kann eine Schicht oder Verteilung von negativ geladenen Ionen (-) aufweisen, die über eine Schicht oder Verteilung von positiv geladenen Ionen (+) gestapelt sind. Es können verschiedene Ionen mit unterschiedlichen Mobilitäten vorhanden sein, z.B. mehr als eine Art von Ionen oder das gleiche Atom/Molekül mit unterschiedlichen Ladungszuständen. Im Allgemeinen hängt die Anzahl und Ausrichtung jeder Gruppe von konzentrierten Ionen, die in dem Verkapselungsmaterial 1004 enthalten sind, von der Anzahl und Art (+ zu - oder - zu +) der Umschaltpunkte für die Spannungspolarität ab, die während jeder Anwendung des Ionenmanipulationsverfahrens durchgeführt werden.

Die Figuren 15A bis 15C veranschaulichen eine Ausführungsform des Entfernens einer oder mehrerer Gruppen konzentrierter Ionen innerhalb des Verkapselungsmaterials einer gepackten Halbleitervorrichtung. Jede Gruppe von konzentrierten Ionen wird mit dem hierin beschriebenen Ionenmanipulationsverfahren hergestellt. Die verpackte Halbleitervorrichtung 1100 beinhaltet einen Halbleiterdie 1102 und ein Verkapselungsmaterial 1104, das den Halbleiterdie 1102 kontaktiert. Die verpackte Halbleitervorrichtung 1100 kann mehr als einen Halbleiterdie 1102 beinhalten. Ein Halbleiterchip 1102 ist in den Figuren 15A bis 15C nur zur besseren Veranschaulichung dargestellt.

Figur 15A zeigt die verpackte Halbleitervorrichtung 1100 mit zwei Gruppen von konzentrierten Ionen 1106, 1108 innerhalb des Verkapselungsmaterials 1104. Im Allgemeinen kann das hierin beschriebene Ionenmanipulationsverfahren mehr oder weniger Gruppen von konzentrierten Ionen innerhalb des Verkapselungsmaterials 1104 erzeugen, deren Anzahl und (+/-) Ausrichtung von der Spannungspolarität und der Anzahl der Spannungspolaritätsumschaltpunkte abhängt, die während jeder Anwendung des Ionenmanipulationsverfahrens durchgeführt werden.

Figur 15B zeigt die verpackte Halbleitervorrichtung 1100, nachdem die oberste Gruppe 1108 konzentrierter Ionen innerhalb des Verkapselungsmaterials 1104 durch Verdünnen des Verkapselungsmaterials 1104 entfernt wurde, z.B. durch Ätzen, Schleifen, Auswaschen, etc. Alternativ kann das Verkapselungsmaterial 1104 selektiv geätzt werden, um Ionen nur einer kritischen Ionenspezies zu entfernen, ohne die gesamte Vorrichtung verdünnen zu müssen. In noch einer weiteren Ausführungsform kann eine spezifische chemische Reaktion auf das Verkapselungsmaterial 1104 angewendet werden, um Ionen zu entfernen, die starr an den äußeren Bereich des Verkapselungsmaterials 1104 gebunden sind.

Figur 15C zeigt die verpackte Halbleitervorrichtung 1100, nachdem alle Gruppen 1106, 1108 konzentrierte Ionen innerhalb des Verkapselungsmaterials 1104 durch Verdünnen des Verkapselungsmaterials 1104 entfernt wurden, z.B. durch Ätzen, Schleifen, Auswaschen, etc. Daher kann die fertig verpackte Halbleitervorrichtung 1100 null, eine oder eine Vielzahl von Gruppen konzentrierter Ionen innerhalb des Verkapselungsmaterials 1104 der verpackten Halbleitervorrichtung 1100 beinhalten. Jede Gruppe von konzentrierten Ionen, die in dem Verkapselungsmaterial 1104 der fertig verpackten Halbleitervorrichtung 1100 enthalten ist, kann eine Schicht oder Verteilung von positiv (+) oder negativ (-) geladenen Ionen aufweisen, die über eine Schicht oder Verteilung des gegenüberliegenden Ionentyps gestapelt ist. Jede Gruppe von Ionen kann in einem weniger kritischen Bereich des Verkapselungsmaterials 1104 konzentriert werden, was weniger Einfluss auf die elektrischen Parameter und die Funktionalität des Halbleiterdie 1102 in Kontakt mit dem Verkapselungsmaterial 1104 hat.

Figur 16 veranschaulicht eine Ausführungsform einer verpackten Halbleitervorrichtung 1200, die mit dem hierin beschriebenen Ionenmanipulationsverfahren verarbeitet wurde. Die verpackte Halbleitervorrichtung 1200 beinhaltet einen Halbleiterdie 1202 und ein Verkapselungsmaterial 1204, das den Halbleiterdie 1202 kontaktiert. Die verpackte Halbleitervorrichtung 1200 kann mehr als einen Halbleiterdie 1202 beinhalten. Ein Halbleiterdie 1202 ist in Figur 16 nur zur besseren Veranschaulichung dargestellt.

Die verpackte Halbleitervorrichtung 1200 beinhaltet auch eine Getterstruktur 1206, wie beispielsweise eine dem Verkapselungsmaterial 1204 zugegebene Schicht, eine Oberflächenstruktur des Verkapselungsmaterials 1204 mit erhöhter Rauhigkeit, eine behandelte Oberfläche des Verkapselungsmaterials 1204, etc. Die Getterstruktur 1206 gettert oder fängt Konzentrationen von Ionen 1208, 1210 ein, die sich nach dem Ionenmanipulationsverfahren von der Oberfläche des Halbleiterdie 1202 entfernt haben. Die Getterstruktur 11206 verhindert oder reduziert zumindest die Migration der Ionenkonzentrationen 1208, 1210 nach der Endaushärtung des Verkapselungsmaterials 1204. Zusätzlich oder alternativ kann die ionische Kontamination innerhalb des Verkapselungsmaterials 1204 durch Reinigen, Ätzen, Auslaugen usw. des Verkapselungsmaterials 1204 weiter reduziert werden.

Räumlich relative Begriffe wie "unter", "unterhalb", "niedriger", "oberhalb", "über" und dergleichen werden zur besseren Beschreibung verwendet, um die Positionierung eines Elements gegenüber einem zweiten Element zu erklären. Diese Begriffe sollen verschiedene Orientierungen umfassen, einschließlich anderer Orientierungen als die in den Abbildungen dargestellten. Darüber hinaus werden Begriffe wie "erste", "zweite" und dergleichen auch zur Beschreibung verschiedener Elemente, Regionen, Abschnitte usw. verwendet und sind ebenfalls nicht als Einschränkung gedacht. Ähnliche Begriffe beziehen sich auf ähnliche Elemente in der gesamten Beschreibung.

Wie hierin verwendet, sind die Begriffe "Haben", "Enthalten", "Einschließen", "Umfassen" und dergleichen offene Begriffe, die auf das Vorhandensein angegebener Elemente oder Merkmale hinweisen, jedoch keine zusätzlichen Elemente oder Merkmale ausschließen. Die Artikel "ein", "eine" und "der/die/das" sollen sowohl den Plural als auch den Singular beinhalten, sofern der Kontext nichts anderes bestimmt.

In Anbetracht der oben genannten Varianten und Anwendungen ist zu verstehen, dass die vorliegende Erfindung weder durch die vorstehende Beschreibung noch durch die beigefügten Zeichnungen eingeschränkt ist. Vielmehr ist die vorliegende Erfindung nur durch die folgenden Ansprüche und deren rechtliche Entsprechung begrenzt.

## Patentansprüche

1. Verfahren, umfassend:
Verarbeiten eines Verkapselungsmaterials für eine Halbleitervorrichtung, wobei das Verkapselungsmaterial Ionen enthält, die eine Mobilität aufweisen, die beim Aushärten des Verkapselungsmaterials abnimmt; und
Anlegen eines elektrischen Feldes an das Verkapselungsmaterial, bevor das Verkapselungsmaterial endgültig ausgehärtet wird, um die Menge der im Verkapselungsmaterial enthaltenen Ionen zu reduzieren und/oder die im Verkapselungsmaterial enthaltenen Ionen in einem oder mehreren Bereichen des Verkapselungsmaterials zu konzentrieren.

2. Verfahren nach Anspruch 1, wobei das Anlegen des elektrischen Feldes an das Verkapselungsmaterial vor dem endgültigen Aushärten des Verkapselungsmaterials das Anlegen einer Spannung an mindestens ein Elektrodenpaar in unmittelbarer Nähe des Verkapselungsmaterials umfasst, so dass die im Verkapselungsmaterial enthaltenen positiven Ionen von jeder negativ geladenen Elektrode des mindestens einen Elektrodenpaares angezogen werden und die im Verkapselungsmaterial enthaltenen negativen Ionen von jeder positiv geladenen Elektrode des mindestens einen Elektrodenpaares angezogen werden.

3. Verfahren nach Anspruch 2, wobei das mindestens eine Elektrodenpaar in direktem Kontakt mit dem Verkapselungsmaterial steht.

4. Verfahren nach einem der Ansprüche 1 bis 3, wobei das an das Verkapselungsmaterial angelegte elektrische Feld konstant ist.

5. Verfahren nach einem der Ansprüche 1 bis 4, ferner umfassend:
Ändern des an das Verkapselungsmaterial angelegten elektrischen Feldes.

6. Verfahren nach einem der Ansprüche 1 bis 5, wobei das Verarbeiten des Verkapselungsmaterials das Treiben eines verflüssigten Basismaterials durch eine Leitung umfasst, das zum Bilden des Verkapselungsmaterials verwendet wird, und wobei das Anlegen des elektrischen Feldes an das Verkapselungsmaterial, bevor das Verkapselungsmaterial schließlich ausgehärtet wird, das Anlegen einer Spannung an mindestens ein Paar von Elektroden umfasst, die außerhalb der Leitung angeordnet sind, innerhalb der Leitung angeordnet sind oder die Teil der Leitung bilden.

7. Verfahren nach einem der Ansprüche 1 bis 6, wobei das Verarbeiten des Verkapselungsmaterials das Treiben des Verkapselungsmaterials in einem ungehärteten Zustand durch eine Leitung umfasst, und wobei das Anlegen des elektrischen Feldes an das Verkapselungsmaterial, bevor das Verkapselungsmaterial schließlich ausgehärtet wird, das Anlegen einer Spannung an mindestens ein Paar von Elektroden umfasst, die außerhalb der Leitung angeordnet sind, innerhalb der Leitung angeordnet sind oder die Teil der Leitung bilden.

8. Verfahren nach einem der Ansprüche 1 bis 7, wobei das Verarbeiten des Verkapselungsmaterials das Einsetzen des Verkapselungsmaterials in eine Kammer oder einen Formhohlraum, der die Halbleitervorrichtung hält, umfasst, und wobei das Anlegen des elektrischen Feldes an das Verkapselungsmaterial, bevor das Verkapselungsmaterial schließlich ausgehärtet wird, das Anlegen einer Spannung an eine von der Halbleitervorrichtung bereitgestellte erste Elektrode und eine von der Halbleitervorrichtung beabstandete zweite Elektrode in der Kammer oder dem Formhohlraum umfasst.

9. Verfahren nach einem der Ansprüche 1 bis 8, wobei das Verarbeiten des Verkapselungsmaterials das Aushärten des Verkapselungsmaterials in einem Aushärteofen umfasst, nachdem das Verkapselungsmaterial an die Halbleitervorrichtung angelegt wurde, und wobei das Anlegen des elektrischen Feldes an das Verkapselungsmaterial, bevor das Verkapselungsmaterial schließlich ausgehärtet wird, das Anlegen einer Spannung an eine von der Halbleitervorrichtung bereitgestellte erste Elektrode und eine von der Halbleitervorrichtung beabstandete zweite Elektrode im Aushärteofen umfasst.

10. Verfahren nach Anspruch 9, ferner umfassend eines von:
Verdünnen des Verkapselungsmaterials nach dem Aushärten im Aushärteofen;
selektives Ätzen des Verkapselungsmaterials nach dem Aushärten im Aushärteofen; und
Anwenden einer spezifischen chemischen Reaktion auf das Verkapselungsmaterial nach dem Aushärten im Aushärteofen.

11. Halbleitervorrichtung, umfassend:
einen Halbleiterdie;
ein Verkapselungsmaterial, das den Halbleiterdie kontaktiert; und
eine erste Gruppe von Ionen, die in dem Verkapselungsmaterial in einem ersten Abstand von dem Halbleiterdie konzentriert sind.

12. Halbleitervorrichtung nach Anspruch 11, worin die erste Gruppe von Ionen eine Verteilung von positiv geladenen Ionen umfasst, die von einer Verteilung von negativ geladenen Ionen versetzt ist.

13. Halbleitervorrichtung nach Anspruch 11 oder 12, ferner umfassend eine zweite Gruppe von Ionen, die in dem Verkapselungsmaterial in einem zweiten Abstand von dem Halbleiterdie größer als der erste Abstand konzentriert sind.

14. Halbleitervorrichtung nach Anspruch 13, worin die erste Gruppe von Ionen eine erste Verteilung von positiv geladenen Ionen umfasst, die von einer ersten Verteilung von negativ geladenen Ionen versetzt ist, und worin die zweite Gruppe von Ionen eine zweite Verteilung von positiv geladenen Ionen umfasst, die von einer zweiten Verteilung von negativ geladenen Ionen versetzt ist.

15. Vorrichtung, umfassend:
ein Gehäuse, das konfiguriert ist, um ein Verkapselungsmaterial für eine Halbleitervorrichtung aufzunehmen, wobei das Verkapselungsmaterial Ionen enthält, die eine Mobilität aufweisen, die abnimmt, wenn das Verkapselungsmaterial aushärtet;
mindestens ein Paar Elektroden, die konfiguriert sind, um ein elektrisches Feld an das vom Gehäuse aufgenommene Verkapselungsmaterial anzulegen, bevor das Verkapselungsmaterial endgültig ausgehärtet ist, um die Menge der im Verkapselungsmaterial enthaltenen Ionen zu reduzieren und/oder die im Verkapselungsmaterial enthaltenen Ionen in einem oder mehreren Bereichen des Verkapselungsmaterials zu konzentrieren; und
eine Energiequelle, die konfiguriert ist, um eine Spannung über das mindestens eine Paar von Elektroden bereitzustellen.

16. Vorrichtung nach Anspruch 15, wobei die Umhüllung eine Leitung ist, die konfiguriert ist, um ein verflüssigtes Basismaterial zu tragen, das zum Bilden des Verkapselungsmaterials verwendet wird, oder um das Verkapselungsmaterial in einem ungehärteten Zustand in eine Kammer oder einen Formhohlraum zu tragen, und wobei das mindestens eine Elektrodenpaar außerhalb der Leitung, innerhalb der Leitung angeordnet oder Teil der Leitung ist.

17. Vorrichtung nach Anspruch 15 oder 16, wobei das Gehäuse eine Kammer oder ein Formhohlraum ist, der konfiguriert ist, um die Halbleitervorrichtung und das Verkapselungsmaterial aufzunehmen, und wobei das mindestens eine Paar von Elektroden eine erste Elektrode, die von der Halbleitervorrichtung bereitgestellt wird, und eine zweite Elektrode, die von der Halbleitervorrichtung in der Kammer oder dem Formhohlraum beabstandet ist, umfasst.

18. Vorrichtung nach Anspruch 17, wobei die Kammer oder der Formhohlraum die zweite Elektrode bildet.

19. Vorrichtung nach einem der Ansprüche 15 bis 17, wobei das Gehäuse ein Aushärteofen ist, der konfiguriert ist, um das Verkapselungsmaterial auszuhärten, nachdem das Verkapselungsmaterial auf die Halbleitervorrichtung aufgebracht wurde, und wobei das mindestens eine Elektrodenpaar eine erste Elektrode, die von der Halbleitervorrichtung bereitgestellt wird, und eine zweite Elektrode, die von der Halbleitervorrichtung im Aushärteofen beabstandet ist, umfasst.

20. Vorrichtung nach Anspruch 19, wobei der Aushärteofen ein Gestell umfasst, auf dem die Halbleitervorrichtung während des Aushärtens des Verkapselungsmaterials ruht, und wobei das Gestell die zweite Elektrode bildet.
